# EUROPEAN PATENT APPLICATION

(11) **EP 4 825 830 A1**
(43) Date of publication of application: **21.10.2026**
(21) Application number: 24903783.9
(22) Date of filing: 13.12.2024
(51) Int. Cl.: C04B 35/587, C04B 37/02, H05K 1/03

(54) **SILICON NITRIDE SINTERED BODY AND SILICON NITRIDE CIRCUIT BOARD**

(30) Priority: 14.12.2023 JP 2023211268
(71) Applicant: Niterra Materials Co., Ltd., Kanagawa 235-0032 (JP)
(72) Inventor: YAMAGATA, Yoshihito, Yokohama-shi, Kanagawa 235-0032 (JP); AOKI, Katsuyuki, Yokohama-shi, Kanagawa 235-0032 (JP); TAKEUCHI, Yuta, Yokohama-shi, Kanagawa 235-0032 (JP)
(74) Representative: Hoffmann Eitle
(86) International application number: PCT/JP2024/044167
(87) International publication number: WO 2025/127130

(57) **Abstract**

A silicon nitride sintered body according to an embodiment of the present invention comprises silicon nitride crystal particles. Observation by SEM of an area of 256 µm × 172 µm in an arbitrary first cross-section of the silicon nitride sintered body reveals that the ratio of a second number of silicon nitride crystal particles having an aspect ratio of 2 or less and a short diameter of 1.8 µm to 2.2 µm to a first number of silicon nitride crystal particles having an aspect ratio of 2 or less is in the range from 5% to 20%.

## Description

### [Technical Field]

Embodiments described below relate generally to a silicon nitride sintered body and a silicon nitride circuit board.

### [Background Art]

Silicon nitride sintered bodies are used in various fields, such as substrates for semiconductor devices and bearing balls. For example, Japanese Patent No. 6293772 (Patent Literature 1) discloses a silicon nitride substrate having a thermal conductivity of 50 W/m·K or more. In the technique described in Patent Literature 1, the average particle size of the long diameters of the silicon nitride crystal grains is controlled to 1.5 µm to 10 µm. In the technique described in Japanese Patent No. 5380277 (Patent Literature 2), the silicon nitride particles include needle-shaped crystal grains. The long diameters L of the needle-shaped crystal grains are controlled to 10 µm or less, and the ratio (L/S) of the long diameter L to the short diameter S is controlled to 5 or more.

In the techniques described in Patent Literature 1 and Patent Literature 2, the long diameters of the silicon nitride crystal grains are controlled. In silicon nitride sintered bodies, columnar silicon nitride crystal grains having a large aspect ratio are intricately entangled to attain high strength.

### [Prior Art Documents]

### [Patent Literature]

[Patent Literature 1] Japanese Patent No. 6293772
[Patent Literature 2] Japanese Patent No. 5380277

### [Summary of Invention]

### [Problem to be Solved by the Invention]

In the silicon nitride sintered body described in Patent Literature 1 or Patent Literature 2, a phenomenon in which the mechanical characteristics are degraded has sometimes occurred depending on the stress acting direction. An investigation of the cause of this phenomenon has revealed involvement of the distribution of the short diameters of the silicon nitride crystal grains. Patent Literature 1 and Patent Literature 2 have focused only on the long diameters and have not controlled the short diameters of the silicon nitride crystal grains.

Embodiments described herein address such problems and provide a silicon nitride sintered body and a silicon nitride circuit board for which the distribution of the short diameters of silicon nitride crystal grains is controlled.

### [Means for Solving the Problem]

A silicon nitride sintered body according to an embodiment includes silicon nitride crystal grains. In a case where an area of 256 µm × 172 µm in a first cross section is observed with an SEM, the first cross section being any cross section of the silicon nitride sintered body, a percentage of a second number of silicon nitride crystal grains having an aspect ratio of 2 or less and a short diameter of not less than 1.8 µm and not more than 2.2 µm to a first number of silicon nitride crystal grains having an aspect ratio of 2 or less is within a range of not less than 5% and not more than 20%.

### [Brief Description of Drawings]

[FIG. 1] FIG. 1 is a diagram showing an example cross-sectional structure of a silicon nitride sintered body according to an embodiment.
[FIG. 2] FIG. 2 is a diagram showing an example silicon nitride substrate.
[FIG. 3] FIG. 3 is a diagram showing an example silicon nitride circuit board.

### [Description of Embodiments]

A silicon nitride sintered body according to an embodiment includes silicon nitride crystal grains. In a case where an area of 256 µm × 172 µm in a first cross section is observed with an SEM, the first cross section being any cross section of the silicon nitride sintered body, a percentage of a second number of silicon nitride crystal grains having an aspect ratio of 2 or less and a short diameter of not less than 1.8 µm and not more than 2.2 µm to a first number of silicon nitride crystal grains having an aspect ratio of 2 or less is within a range of not less than 5% and not more than 20%.

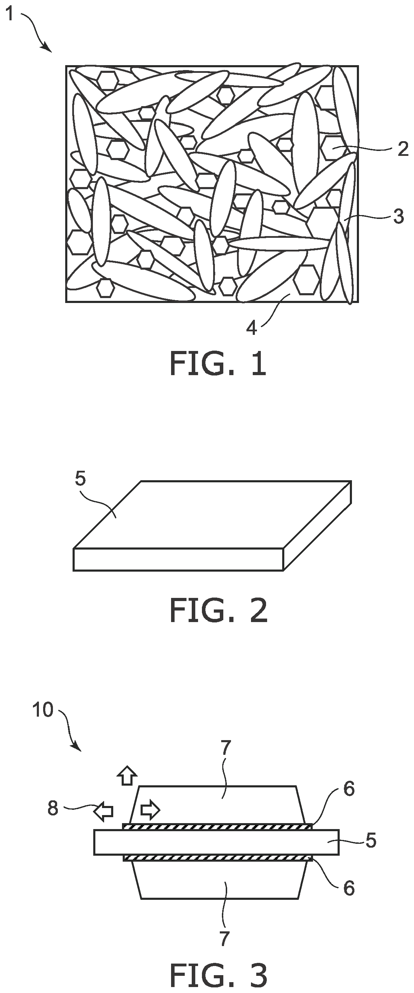

FIG. 1 is a schematic diagram showing an example cross-sectional structure of a silicon nitride sintered body according to an embodiment. In FIG. 1, reference numeral 1 indicates a cross-sectional structure, reference numeral 2 indicates silicon nitride crystal grains having an aspect ratio of 2 or less, reference numeral 3 indicates silicon nitride crystal grains having an aspect ratio exceeding 2, and reference numeral 4 indicates a grain boundary phase.

The cross-sectional structure 1 is a structure in any cross section of the silicon nitride sintered body. The cross-sectional structure 1 includes the silicon nitride crystal grains 2 having an aspect ratio of 2 or less, the silicon nitride crystal grains 3 having an aspect ratio exceeding 2, and the grain boundary phase 4. Pores (not illustrated) may be present in the cross-sectional structure 1. Here, the silicon nitride crystal grains 2 having an aspect ratio of 2 or less may be referred to as spherical silicon nitride crystal grains 2. The silicon nitride crystal grains 3 having an aspect ratio exceeding 2 may be referred to as columnar silicon nitride crystal grains 3. The spherical silicon nitride crystal grains 2 may include spherical SiAlON crystal grains. The columnar silicon nitride crystal grains 3 may include columnar SiAlON crystal grains. A SiAlON grain refers to a compound that contains Si, Al, O, and N as constituent elements.

"Aspect ratio" refers to the ratio of the short diameter to the long diameter. On the outer edge of one silicon nitride crystal grain, two points between which the distance is largest are set. The maximum distance between the two points is "long diameter". A straight line passing through the midpoint of a line segment connecting the two points and orthogonal to the line segment is set. The distance between two points at which the orthogonal straight line and the outer edge of the silicon nitride crystal grain intersect is "short diameter".

The cross-sectional structure 1 has a structure in which the spherical silicon nitride crystal grains 2 and the columnar silicon nitride crystal grains 3 are intricately entangled. In the space between the spherical silicon nitride crystal grains 2 and the columnar silicon nitride crystal grains 3, the grain boundary phase 4 is present.

The cross-sectional structure 1 is obtained by observing with an SEM, a measurement area of 256 µm × 172 µm in any cross section. In the observation with the scanning electron microscope (SEM), the measurement area is photographed at a 500-fold magnification. If the size of the measurement area is larger than 256 µm × 172 µm, the resolution may be decreased.

As will be described below, at least five measurement areas of 256 µm × 172 µm are observed, and a number percentage is measured based on the observation results. If the area of one measurement area is equivalent to 256 µm × 172 µm, the length in the longitudinal direction and the length in the transverse direction of the measurement area may be changed. The orientations of the longitudinal direction and the transverse direction with respect to the silicon nitride sintered body can also be changed as appropriate. A plurality of measurement areas each having an area smaller than 256 µm × 172 µm and adjacent to each other may be observed. In this case, the results of observation of the plurality of measurement areas having an area equivalent to 256 µm × 172 µm are used as the result of observation of one measurement area. Here, a measurement area of 256 µm × 172 µm is used as an easily measured area. The size of the measurement area of 256 µm × 172 µm enables observation of a number of silicon nitride crystal grains sufficient for quantitative evaluation.

In a case where five measurement areas of 256 µm × 172 µm are observed, the number of silicon nitride crystal grains having an aspect ratio of 2 or less is approximately 5000 or more. A number percentage for which the influence of, for example, coarse particles is reduced can be calculated.

As the SEM, JCM-7000 or JSM-7200F from JOEL or an apparatus having performance equivalent or higher than that of JCM-7000 or JSM-7200F is used. The cross-sectional SEM photograph may be simply referred to as "SEM photograph". As the SEM photograph, a secondary electron image is used.

A method for analyzing the cross-sectional structure 1 will be described. The cross-sectional structure 1 has a structure in which the spherical silicon nitride crystal grains 2 and the columnar silicon nitride crystal grains 3 are intricately entangled. The silicon nitride crystal grains are oriented at random. Even a silicon nitride crystal grain having a large aspect ratio becomes the spherical silicon nitride crystal grain 2 or the columnar silicon nitride crystal grain 3 in the cross-sectional structure 1 depending on the orientation direction. The spherical silicon nitride crystal grains 2 may be originally spherical crystal grains, such as α-SiAlON crystal grains.

From the SEM photograph, the sizes of relatively large particles can be grasped. However, it is difficult to directly grasp the sizes and distribution of small particles, such as spherical particles, from the SEM photograph. In the embodiment, the following analytical processing is performed on the SEM photograph.

For the analysis, an image of 1280 by 1024 pixels is prepared. In the analytical processing, image analysis software is used. The executable file of the image analysis software is, for example, SemAnalyzer.exe. On the prepared image, steps 1 to 4 below are performed.

### (Step 1)

The image is slightly smoothed (blurred) without disappearance of the outlines of silicon nitride crystal grains (including SiAlON crystal grains). The smoothing can remove noise caused by very small irregularities on the surface of the sample. The image subjected to the smoothing is referred to as "smoothed image". In the operation of the executable file, the numerical value in the line under "# smooth ..." in the configuration file is corrected. The numerical value indicates the density (roughness) of the smoothing filter, and the density of the filter for removing noise is set without disappearance of the outlines of silicon nitride crystal grains.

### (Step 2)

Due to the influence of large irregularities on the surface of the sample, the dispersion of the luminance distribution may become large in the SEM photograph. A process for reducing the dispersion of the luminance distribution is performed. First, the smoothed image is divided into grids (in a grid shape). The number of divided grids is set to nine or more.

Each grid includes a plurality of pixels. For each grid, the median of luminance values in the pixels is calculated. The luminance value is an index of luminance, and a pixel has a luminance value as its pixel value. After the calculation of the medians for the respective grids, the average of the medians is calculated. Next, the difference between the average and the median is calculated for each grid. The luminance values of the pixels included in each grid are corrected so that the difference becomes smaller. Preferably, the correction is made so that the difference between the median and the average becomes equal to around zero (including zero) in each grid. This makes the luminance difference between the grids uniform, and the grids are smoothly connected as a whole to create a bias image. The bias image is subtracted from the smoothed image to generate an image normalized, from which the luminance differences in the image are subtracted.

The image normalized is referred to as "normalized image". For one measurement area of 256 µm × 172 µm, one normalized image is obtained. When five measurement areas of 256 µm × 172 µm are observed, five normalized images are obtained.

In the operation of the executable file, numerical values representing the number of grids in the transverse direction and that in the longitudinal direction are edited in the configuration file. The numerical values are set to nine or more. In a case where the dispersion of the luminance distribution is small in the SEM image and normalization of the luminance distribution in the image is not necessary, the number of grids in either the transverse direction or the longitudinal direction can be set to zero to omit this process. For example, in a case where the observation surface is polished, the dispersion of the luminance distribution may be sufficiently small.

### (Step 3)

In order to reduce variations in the luminance distribution among the at least five images, the luminance distribution is further corrected. The entire signal value histogram of each of the normalized images or smoothed images is regarded as a normal distribution, and the luminance values of each image are linearly transformed so as to obtain standard normal distributions among which the full width at half maximum is coincident. The image subjected to the linear transformation is referred to as "linearly transformed image". In other words, the at least five smoothed images or normalized images are corrected, and thereafter, their frequency histograms are generated and averaging is performed to perform the linear transformation. In step 3, an adjustment parameter of the executable file is not present.

### (Step 4)

The particle shapes of silicon nitride crystal grains clearly shown in the linearly transformed image are extracted. In this process, the grain boundary phase is excluded from the extraction. In the operation of the executable file, the minimum size of the silicon nitride crystal grain diameter is set to 2.0 pixels. In this case, particles whose circumscribed circle has a radius of less than 2.0 pixels are excluded from the extraction. The minimum size of the silicon nitride particle diameter can be adjusted by changing the numerical value of "th_dis" in the configuration file. The threshold value of the aspect ratio can be adjusted by changing the numerical value of "th_shape" . When the threshold value of the aspect ratio is adjusted, SiN particles having a large aspect ratio on the image can be excluded from the extraction. For example, the threshold value of the aspect ratio can be set to 2.0 by setting the minimum size to 2.0 pixels. In other words, silicon nitride crystal grains having an aspect ratio exceeding 2.0 on the image can be excluded from the extraction. By this operation, silicon nitride crystal grains having an aspect ratio of 2 or less can be quantified.

The above-described analysis method can be substituted by image processing software ImageJ. In a case where ImageJ is used, the image is analyzed in four steps as in SemAnalyzer.exe.

### (Step 1)

A smoothed image is created from the SEM image. In the executable file, a smoothing filter is applied. As the filter, use "Process" → "smooth". A Gaussian blur can also be used as the filter.

### (Step 2)

A normalized image is created from the smoothed image. First, the smoothed image created in step 1 is divided into nine cells. Select "Grid" in "Tools" from "Analyze" on the menu bar, and set the number of rows and the number of columns to "3" to create a grid divided into nine cells. The number of divided grid cells is preferably nine or more. Therefore, the number of rows and the number of columns are preferably set to three or more.

Next, ROI regions are set. Open "ROI Manager" in "Tools" from "Analyze" on the menu bar, and add each cell of the grid to "ROI Manager". The median of the luminance values is calculated. Select "Set Measurements" from "Analyze" on the menu bar, and check "Median". Select each ROI in "ROI Manager", and click "Measure". Accordingly, the median of the luminance values in each grid is calculated. The average of the plurality of medians is calculated. The difference between the average and the median is calculated for each grid. The luminance values of the pixels included in each grid are corrected so that the difference becomes smaller. To make this correction, select each ROI in "ROI Manager" and select "File" in "Edit" from the menu bar. Select "Median" as "File" option, and repeat this operation for each grid cell to create a bias image. The bias image is subtracted from the smoothed image to generate an image in which the luminance of the entire image is normalized.

### (Step 3)

In order to create a linearly transformed image, the luminance values are linearly transformed. The method for linear transformation is similar to that in the case of using SemAnalyzer.exe.

### (Step 4)

The particle shapes of silicon nitride crystal grains are extracted from the linearly transformed image obtained in step 3. First, display the "Bright & Contrast" window, operate "Minimum" and "Maximum", and place the cursor over the left tail of the histogram. Select "Process" → "Noise" → "Despeckle" to remove noise. Binarize the image ("Process" → "Binary" → "Make Binary"), and select "Analyze Particles" in "Analyze" to analyze the particles. Check data displayed in the "Results" window, and filter silicon nitride crystal grains having an aspect ratio of 2 or less, based on the aspect ratio (Major/Minor).

Any cross section of the silicon nitride sintered body is analyzed by the above-described method. With the above-described analysis method, the number of silicon nitride crystal grains having an aspect ratio of 2 or less can be measured. In a case where a measurement area of 256 µm × 172 µm is observed with the SEM for the silicon nitride sintered body according to the embodiment, the percentage of a second number to a first number is within a range of not less than 5% and not more than 20%. The first number is the total number of silicon nitride crystal grains having an aspect ratio of 2 or less. The second number is the number of silicon nitride crystal grains having an aspect ratio of 2 or less and a short diameter of not less than 1.8 µm and not more than 2.2 µm. Further, with the above-described analysis method, in a case where, for example, five measurement areas of 256 µm × 172 µm are analyzed, 5000 or more silicon nitride crystal grains having an aspect ratio of 2 or less are observed.

The embodiment is characterized in that the percentage of the number (second number) of silicon nitride crystal grains having an aspect ratio of 2 or less and a short diameter of not less than 1.8 µm and not more than 2.2 µm to the number (first number) of silicon nitride crystal grains having an aspect ratio of 2 or less is within a range of not less than 5% and not more than 20%. In other words, [(number of silicon nitride crystal grains having aspect ratio of 2 or less and short diameter of not less than 1.8 µm and not more than 2.2 µm/number of silicon nitride crystal grains having aspect ratio of 2 or less)] × 100 = 5% to 20% holds.

Since the percentage of the second number to the first number is within a range of not less than 5% and not more than 20%, a decrease in three-point bending strength against stress can be suppressed in the direction perpendicular to the observation surface. Here, the percentage of the second number to the first number is referred to as "number percentage A". If the number percentage A is less than 5%, the amount of existing silicon nitride crystal grains having an aspect ratio of 2 or less and a short diameter of not less than 1.8 µm and not more than 2.2 µm is small. The silicon nitride crystal grains having an aspect ratio of 2 or less and a short diameter of not less than 1.8 µm and not more than 2.2 µm contribute to improvement of three-point bending strength, but may cause a decrease in thermal conductivity. If the number percentage A is less than 5%, the three-point bending strength of the silicon nitride sintered body may decrease. If the number percentage A exceeds 20%, the thermal conductivity of the silicon nitride sintered body may decrease. Therefore, the number percentage A is preferably within a range of not less than 5% and not more than 20%, and more preferably within a range of not less than 8% and not more than 18%.

In the embodiment, no matter how the five measurement areas of 256 µm × 172 µm are set in a cross section, the number percentage A in the measurement results is within a range of not less than 5% and not more than 20%. Preferably, the number percentage A is within a range of not less than 5% and not more than 20% in all of the measurement areas of 256 µm × 172 µm.

Silicon nitride sintered bodies have a structure in which silicon nitride crystal grains having various sizes are intricately dispersed. Even in the seemingly non-oriented structure, the three-point bending strength has decreased depending on the direction of stress application. The control of the number percentage A can suppress a decrease in the three-point bending strength against stress in the direction perpendicular to the observation surface. Any cross section is used as the observation surface. In other words, no matter how the silicon nitride sintered body is cut, the number percentage A is within a range of not less than 5% and not more than 20% in the cross section. Therefore, a decrease in three-point bending strength against stress can be suppressed in all directions.

For example, the silicon nitride sintered body is cut in any direction to obtain a first cross section. Next, the silicon nitride sintered body is cut in the direction perpendicular to the first cross section to obtain a second cross section. Further, the silicon nitride sintered body is cut in the direction perpendicular to the first cross section and the second cross section to obtain a third cross section. In all of the first cross section, the second cross section, and the third cross section, in a case where five measurement areas of 256 µm × 172 µm are observed with the SEM, the number percentage A is within a range of not less than 5% and not more than 20%.

The percentage of the number (third number) of silicon nitride crystal grains having an aspect ratio of 2 or less and a short diameter of 4.0 µm or more to the first number is preferably within a range of not less than 0% and not more than 10%. Here, the percentage of the third number to the first number is referred to as "number percentage B". The silicon nitride crystal grains having an aspect ratio of 2 or less and a short diameter of 4.0 µm or more are relatively large crystal grains. If the number percentage B exceeds 10% and the number of large crystal grains increases, it contributes to improvement of thermal conductivity, but may cause a decrease in three-point bending strength in a stress acting direction. Therefore, the number percentage B is preferably 10% or less.

The large crystal grains have the effect of improving thermal conductivity. In a case of increasing the thermal conductivity of the silicon nitride sintered body to 90 W/m ·K or more, the number percentage B is preferably within a range of not less than 0.01% and not more than 10%, and more preferably within a range of not less than 0.02% and not more than 5%.

The upper limit of the short diameters of the silicon nitride crystal grains having an aspect ratio of 2 or less is not specifically limited. Preferably, the maximum value of the short diameters is less than 15 µm. If large crystal grains having a short diameter exceeding 15 µm are present, the control of, for example, the number percentage A may become difficult.

The percentage of the number (fourth number) of silicon nitride crystal grains having an aspect ratio of 2 or less and a short diameter of less than 1.8 nm to the first number is preferably within a range of not less than 45% and not more than 75%. Here, the percentage of the fourth number to the first number is referred to as "number percentage C". The silicon nitride crystal grains having an aspect ratio of 2 or less and a short diameter of less than 1.8 µm are relatively small crystal grains. For example, a large number of small crystal grains can be placed between silicon nitride crystal grains having a short diameter exceeding 2.2 µm. Therefore, the number percentage C is larger than the number percentage A and the number percentage B.

The orientation direction of the small crystal grains is less likely to cause a decrease in three-point bending strength in a stress acting direction. Further, the small crystal grains are present in the space between crystal grains having different sizes to make the cross-sectional structure 1 dense. Therefore, the number percentage C is preferably within a range of not less than 45% and not more than 75%, and more preferably within a range of not less than 50% and not more than 75%.

The lower limit of the short diameters of the silicon nitride crystal grains having an aspect ratio of 2 or less is not specifically limited, but is preferably 1 µm or more. If the minimum value of the short diameters is small, the percentage of the fourth number increases, and the control of the number percentage A and the number percentage B may become difficult.

The percentage of the number (fifth number) of silicon nitride crystal grains having an aspect ratio of 2 or less and a short diameter exceeding 2.2 µm and less than 4.0 µm to the first number is preferably within a range of not less than 10% and not more than 25%. The number percentage of the silicon nitride crystal grains having an aspect ratio of 2 or less and a short diameter exceeding 2.2 µm and less than 4.0 µm is referred to as "number percentage D". The silicon nitride crystal grains having an aspect ratio of 2 or less and a short diameter exceeding 2.2 µm and less than 4.0 µm have a medium size. The silicon nitride crystal grains having this size contribute to improvement of three-point bending strength and improvement of thermal conductivity. The presence of a predetermined amount of the number percentage D can suppress a decrease in three-point bending strength in a stress acting direction. The crystal grains having a medium size also contribute to improvement of thermal conductivity.

It is preferable that at least one or more of the number percentage B, the number percentage C, and the number percentage D satisfy the above-described ranges. It is most preferable that the number percentage A be satisfied, and all of the number percentage B, the number percentage C, and the number percentage D satisfy the above-described ranges.

The difference between the number percentage A and the number percentage D is preferably 10% or less. That is, it is preferable that |number percentage A - number percentage D| ≤ 10% hold. The number percentage A relates to the silicon nitride crystal grains having an aspect ratio of 2 or less and a short diameter of not less than 1.8 µm and not more than 2.2 µm, and the number percentage D relates to the silicon nitride crystal grains having an aspect ratio of 2 or less and a short diameter exceeding 2.2 µm and not more than 4.0 µm. Since the difference in number percentage between comparatively small particles and particles having a medium size is small, the space between the silicon nitride crystal grains can be reduced, and this can improve fracture toughness.

The short diameter (D₅₀) of the silicon nitride crystal grains having an aspect ratio of 2 or less is preferably not less than 1.30 µm and less than 1.80 µm. The short diameter (D₅₀) indicates a particle size corresponding to a cumulative frequency of 50% in the distribution of the short diameters of the silicon nitride crystal grains having an aspect ratio of 2 or less. 50% of the silicon nitride crystal grains having an aspect ratio of 2 or less have a short diameter of less than D₅₀. In other words, the short diameter (D₅₀) is also the average particle size (median diameter) of the short diameters of the silicon nitride crystal grains having an aspect ratio of 2 or less. In a specific example, 6000 silicon nitride crystal grains having an aspect ratio of 2 or less are present in five measurement areas of 256 µm × 172 µm. In this case, the short diameter of the 3000th silicon nitride crystal grain when the silicon nitride crystal grains are counted in ascending order of short diameter is the short diameter (D₅₀).

The short diameter (D₁₀₀) of the silicon nitride crystal grains having an aspect ratio of 2 or less is preferably not less than 3.00 µm and less than 15.00 µm. The short diameter (D₁₀₀) indicates a particle size corresponding to a cumulative frequency of 100% in the distribution of the short diameters of the silicon nitride crystal grains having an aspect ratio of 2 or less. That is, the short diameter (D₁₀₀) corresponds to the maximum value of the short diameters of the silicon nitride crystal grains having an aspect ratio of 2 or less.

As described above, the silicon nitride crystal grains having an aspect ratio of 2 or less contribute to improvement of three-point bending strength or improvement of thermal conductivity depending on their short diameters. Further, the silicon nitride crystal grains are entangled with each other to contribute to improvement of fracture toughness. When the average particle size of the short diameters and the maximum diameter of the short diameters are controlled, and the number percentages are controlled, three-point bending strength, thermal conductivity, and fracture toughness can be improved.

The total area percentage of the silicon nitride crystal grains having an aspect ratio of 2 or less is preferably within a range of not less than 30% and not more than 70%. This indicates that (total area of silicon nitride crystal grains having aspect ratio of 2 or less/total area of all silicon nitride crystal grains) × 100 (%) = 30% to 70%. The total area of all silicon nitride crystal grains is the total area of the silicon nitride crystal grains having an aspect ratio of 2 or less and the silicon nitride crystal grains having an aspect ratio exceeding 2. In a case where the relative density of the silicon nitride sintered body is not less than 95% and not more than 100%, the area of the measurement area of 256 µm × 172 µm may be used as the total area of all silicon nitride crystal grains. This is because if the relative density is 95% or more, the influence of the grain boundary phase and pores is sufficiently small. Even in this case, however, the above-described analytical processing is performed in order to calculate the total area of the silicon nitride crystal grains having an aspect ratio of 2 or less.

In the silicon nitride sintered body according to the above-described embodiment, the three-point bending strength can be 400 MPa or more. The thermal conductivity can be 90 W/m ·K or more. The fracture toughness can be 7 MPa·m^{1/2} or more.

The three-point bending strength is measured in accordance with JIS-R-1601 (2008). JIS-R-1601 corresponds to ISO 14704. The thermal conductivity is measured by the flash method. The fracture toughness can be measured in accordance with the IF method of JIS-R-1607 (2015) using Niihara's equation. JIS-R-1607 corresponds to ISO 15732.

The thickness of the silicon nitride sintered body may be not less than 0.2 mm and not more than 3 mm. The silicon nitride sintered body having a thickness of not less than 0.2 mm and not more than 3 mm is referred to as a silicon nitride substrate. FIG. 2 is a perspective view showing an example silicon nitride substrate. In FIG. 2, reference numeral 5 indicates a silicon nitride substrate. Although a quadrangular substrate is illustrated in FIG. 2, the shape of the substrate is not limited to this. The silicon nitride substrate may have any of various shapes, such as a circular shape (including an elliptic shape), an L-shape, or a U-shape. The dimensions of the substrate in the longitudinal direction and the transverse direction can also be designed as desired.

When the silicon nitride substrate is provided with a circuit portion, a silicon nitride circuit board is obtained. A circuit portion may be provided on both faces of the silicon nitride substrate. A circuit portion may be provided on the front face of the silicon nitride substrate and a heat dissipation portion may be provided on the back face thereof.

Any of various members, such as a metal plate, a metallized layer, or a thin film, can be used as the circuit portion and the heat sink. The metal plate is, for example, a copper plate, a copper alloy plate, an aluminum plate, or an aluminum alloy plate. The metal plate is preferably a copper plate made of oxygen-free copper. The oxygen-free copper has a copper purity of 99.96 wt% or more as specified in JIS-H-3100 (for example, ISO 1337).

The thermal conductivity of the copper plate is about 400 W/m·K. The thermal conductivity of the copper plate is higher than the thermal conductivity of aluminum, which is about 240 W/m·K. Therefore, the use of the copper plate as the metal plate can improve the heat dissipation of the silicon nitride circuit board as compared with a case of using an aluminum plate.

The thickness of the metal plate is preferably within a range of not less than 0.2 mm and not more than 5 mm. Making the metal plate thicker can improve the heat dissipation and current carrying capacity. A bonding layer 6 is, for example, an active metal bonding layer. In a case where the metal plate is a copper plate, for example, the active metal bonding layer contains Ti, and contains Ag or Cu as the main component. In a case where the metal plate is an aluminum plate, for example, the active metal bonding layer contains Si, and contains Al as the main component. The active metal bonding layer is a bonding layer containing Ti or Si as the active metal. Although an example in which a metal plate is bonded to the silicon nitride substrate as a circuit portion has been described, the silicon nitride circuit board according to the embodiment is not limited to such a configuration.

The thin film is a metal film formed by a method, such as sputtering or evaporation. The metal thin film contains, for example, Ti, Pt, Au, Ni, Cu, Al, or Ag. The metallized layer is a film formed by sintering a metal paste. The metallized layer may be referred to as a metal thick film. The metallized layer contains, for example, Ag, Cu, Ti, W, or Mo.

FIG. 3 is a side view showing an example silicon nitride circuit board. In FIG. 3, reference numeral 5 indicates the silicon nitride substrate, reference numeral 6 indicates the bonding layer, reference numeral 7 indicates the metal plate, reference numeral 8 indicates stress, and reference numeral 10 indicates a silicon nitride circuit board. The metal plate 7 is bonded to the silicon nitride substrate 5 with the bonding layer 6 interposed. In the example shown in FIG. 3, the metal plate 7 is bonded to both faces of the silicon nitride substrate.

For example, the metal plate 7 on one of the faces is used as a circuit portion, and the metal plate 7 on the other face is used as a heat sink. The silicon nitride circuit board according to the embodiment is not limited to such a structure. For example, the metal plates on the respective faces may be used as circuit portions. A plurality of metal plates may be bonded to one of the faces, and each metal plate may be used as a circuit portion.

The use of thicker metal plates is a recent trend. As a metal plate is thicker, stress applied to the silicon nitride substrate increases. For example, when a thermal cycle test (TCT) is performed, not only tensile stress and compressive stress in the in-plane direction but also upward stretching stress is applied to the bonded end portion of the metal plate. In FIG. 3, tensile stress is shown by the leftward arrow, compressive stress is shown by the rightward arrow, and upward stretching stress is shown by the upward arrow.

In an existing circuit board, cracks have been sometimes generated in the silicon nitride substrate in response to application of tensile stress, compressive stress, or upward stretching stress to the bonded end portion of the metal plate. That is, strength decreases in the direction in which stress acts. This problem is particularly noticeable in a case where the metal plate is thick. Therefore, it has been difficult to attain excellent TCT characteristics because of, for example, cracking easily occurring in the silicon nitride substrate in a TCT. In the silicon nitride substrate according to the embodiment, since the particle sizes are controlled, the occurrence of cracking in the silicon nitride substrate can be suppressed no matter where the bonded end portion of the metal plate is located on the surface of the silicon nitride substrate. This increases the degree of freedom of the position at which the metal plate is bonded.

For example, the silicon nitride circuit board is cut in the thickness direction of the silicon nitride substrate. In a case of observing the cross section with an SEM, a portion of the silicon nitride substrate located immediately below the side end portion of the metal plate is observed. In the silicon nitride circuit board according to the embodiment, in a case where an area of 256 µm × 172 µm located immediately below the side end portion of the metal plate is observed with an SEM, the number percentage A is within a range of not less than 5% and not more than 20%. Preferably, the number percentages B to D are also within the above-described respective ranges. According to the embodiment, the number percentage of the silicon nitride crystal grains having an aspect ratio of 2 or less and a short diameter of not less than 1.8 µm and not more than 2.2 µm is controlled in a portion immediately below the side end portion of the metal plate in which stress tends to concentrate. Accordingly, even if stress is applied to the silicon nitride substrate, a decrease in strength can be suppressed and the occurrence of cracking can be suppressed.

With the silicon nitride substrate according to the embodiment, a decrease in strength in a stress acting direction is suppressed. For example, as the thickness of the metal plate becomes 0.6 mm or more, tensile stress, compressive stress, and upward stretching stress increase. With the silicon nitride substrate according to the embodiment, a decrease in strength against stress acting in the direction perpendicular to any observation surface is suppressed. Therefore, even if stress in any direction increases, excellent TCT characteristics can be attained.

When the number percentage A, the number percentage B, the number percentage C, and the number percentage D are controlled, a cross-sectional structure in which small silicon nitride crystal grains are intricately distributed can be obtained. In a case of bonding a metal plate to the silicon nitride substrate, an active metal bonding method is used. In the active metal bonding method, in a case where Ti (titanium) is used as the active metal, a titanium nitride (TiN) layer is formed between the silicon nitride substrate and the brazing filler. The titanium nitride layer is formed by a reaction between Ti and silicon nitride crystal grains. The structure in which small silicon nitride crystal grains are intricately distributed increases a surface area in which the titanium nitride layer is formed. This improves bonding strength. Further, since partial variations in the bonding strength are suppressed, this leads to improvement of TCT characteristics. In other words, according to the embodiment, a silicon nitride substrate suitable for a silicon nitride circuit board, to which a metal plate is bonded by the active metal bonding method, can be provided.

A method for manufacturing the silicon nitride sintered body according to the embodiment will be described. The method for manufacturing the silicon nitride sintered body according to the embodiment is not limited as long as the silicon nitride sintered body has the above-described configuration. Here, a method for manufacturing the silicon nitride sintered body with a high yield will be described.

First, a silicon nitride powder and a sintering aid powder, which are raw materials, are prepared. The silicon nitride powder is manufactured by, for example, an imide decomposition method or a direct nitridation method. The average particle size of the silicon nitride powder is preferably within a range of not less than 0.1 µm and not more than 4 µm. The particle size Dₚ₁₀₀ of the silicon nitride powder is preferably 10 µm or less. The particle size Dₚ₁₀₀ indicates a particle size corresponding to a cumulative frequency of 100% in the particle size distribution of the silicon nitride powder. In other words, the particle size Dₚ₁₀₀ is the maximum particle size of the silicon nitride powder. If a large number of coarse particles are present in the raw material powder, coarse particles having a short diameter exceeding 4.0 µm are likely to be formed.

As the sintering aid, for example, one or more types selected from among a rare earth element, titanium (Ti), hafnium (Hf), zirconium (Zr), magnesium (Mg), calcium (Ca), tungsten (W), molybdenum (Mo), and a compound thereof are used. The compound may be an oxide, a nitride, or an oxynitride. As the rare earth element, yttrium (Y) or a lanthanoid element may be used. Examples of the lanthanoid element include ytterbium (Yb), erbium (Er), europium (Eu), lutetium (Lu), lanthanum (La), cerium (Ce), and dysprosium (Dy). The average particle size of the sintering aid powder is preferably within a range of not less than 0.1 µm and not more than 4 µm.

When the sum of the silicon nitride powder and the sintering aid powder is assumed to be 100 mass%, the additive amount of the sintering aid is preferably within a range of not less than 1 mass% and not more than 20 mass%. The blended amount of the rare earth element compound in the sintering aid is preferably within a range of not less than 1 mass% and not more than 10 mass%. The rare earth element compound is one or more types selected from among a rare earth element oxide, a rare earth element nitride, and a rare earth element oxynitride. The sintering aid other than the rare earth element compound is preferably one or more types selected from among titanium (Ti), hafnium (Hf), zirconium (Zr), magnesium (Mg), calcium (Ca), tungsten (W), molybdenum (Mo), and a compound thereof.

It is preferable to control the additive amount of the rare earth element compound and that of the sintering aid other than the rare earth element compound. The rare earth element compound improves sinterability and promotes grain growth of the silicon nitride crystal grains in the c-axis direction. The sintering aid other than the rare earth element compound has the effect of forming a grain boundary phase by reacting with the rare earth element compound or the effect of strengthening the grain boundary phase. The additive amount of the rare earth element compound is denoted by A (mol), and the additive amount of the sintering aid other than the rare earth element compound is denoted by B (mol). In a case where the additive molar ratio A/B is low, the aspect ratios of the silicon nitride crystal grains are likely to become small and the short diameter sizes thereof are likely to become large. In a case where the additive molar ratio A/B is high, the aspect ratios of the silicon nitride crystal grains are likely to become large and the short diameter sizes thereof are likely to become small. When the percentage of the rare earth element compound and that of the component other than the rare earth element compound in the sintering aid are controlled, the aspect ratios and the short diameter sizes of the silicon nitride crystal grains can be controlled. The additive molar ratio A/B is preferably 0.5 or more, and more preferably not less than 1.0 and not more than 1.2.

The silicon nitride powder and the sintering aid powder are mixed, and thereafter, a pulverizing process is performed. In the pulverizing process, the powders are mixed and pulverized using a pulverizer. The pulverizer is, for example, a ball mill or a bead mill. The pulverizing process preferably suppresses variations in the particle size of the pulverized particles. The silicon nitride powder and the sintering aid powder before being processed with the pulverizer are often agglomerated. It is preferable to reduce the number of agglomerated particles in the pulverizing process using the pulverizer.

After the pulverizing process, the difference between the particle sizes Dₘₚ₁₀, Dₘₚ₅₀, and Dₘₚ₉₀ of the mixed powder is preferably small. The particle sizes Dₘₚ₁₀, Dₘₚ₅₀, and Dₘₚ₉₀ respectively indicate particle sizes corresponding to cumulative frequencies of 10%, 50% and 90% in the particle size distribution of the mixed powder. That is, 10% of the particles included in the mixed powder have a particle size less than the particle size Dₘₚ₁₀. 50% of the particles included in the mixed powder have a particle size less than the particle size Dₘₚ₅₀. The particle size Dₘₚ₅₀ is also a median diameter. 90% of the particles included in the mixed powder have a particle size less than the particle size Dₘₚ₉₀.

It is preferable that at least either Dₘₚ₅₀ - Dₘₚ₁₀ ≤ 1.0 µm or Dₘₚ₉₀ - Dₘₚ₅₀ ≤ 2.0 µm be satisfied. Regarding the particle sizes, the particle size distribution is measured for any portion weighing 40 mg of the mixed powder subjected to the pulverizing process. To measure the particle size distribution, a laser diffraction method is used.

For example, a binder and a solvent are added to the mixed powder subjected to the pulverizing process to produce a raw material powder slurry. When necessary, the raw material powder slurry may be subjected to a kneading process.

Next, a forming process is performed using the raw material powder slurry. In the forming process, for example, sheet forming, injection molding, or mold molding can be used. In the sheet forming, for example, the doctor blade method is used. In a case of producing a silicon nitride substrate, the doctor blade method is preferable. The use of the doctor blade method improves mass-productivity because a long-length compact can be produced. The compact obtained in the forming process may be cut as needed. In a case of producing a compact in a shape other than the substrate shape, mold molding may be used.

Next, a debinding process is performed on the compact. When the debinding process is performed, a debindered body can be obtained. The debinding process is preferably performed within a range of not less than 400°C and not more than 800°C. With the debinding process, an organic substance, such as the binder, can be removed. The solvent remaining in the compact can also be removed.

In a sintering process, the debindered body is heated in a non-oxidizing atmosphere. The sintering process is performed within a range of not less than 4 hours and not more than 24 hours, and the sintering temperature is set within a range of not less than 1650°C and not more than 1950°C. The non-oxidizing atmosphere is preferably a nitrogen gas atmosphere or a reducing atmosphere including a nitrogen gas. The pressure inside the sintering furnace is preferably a pressurized atmosphere.

If the debindered body is sintered at a sintering temperature of less than 1650°C, a dense sintered body is less likely to be obtained. In contrast, if the debindered body is sintered at a sintering temperature higher than 1950°C, self-decomposition of silicon nitride is likely to occur, and a dense sintered body is less likely to be obtained. Therefore, it is preferable that the sintering temperature be controlled within the above-described range.

The pressure inside the sintering furnace is preferably a pressurized atmosphere of 0.6 MPa or more. Setting the pressurized atmosphere to 0.6 MPa or more can suppress self-decomposition of silicon nitride and suppress grain growth of the silicon nitride crystal grains. Regarding the pressurized atmosphere, it is preferable that the pressurization is started during a period from when the temperature is 1400°C to when the sintering starts.

In the sintering process, it is preferable to use a setter. A setter is, for example, a plate material on which the debindered body is placed, a wall material surrounding the debindered body, or a container storing the debindered body. The material of the setter is, for example, carbon, silicon carbide, or silicon nitride. The setter has a role of preventing the debindered body from being adhered to the inside of the sintering furnace. The setter also has a role of controlling the atmosphere inside the sintering furnace.

The debindered body is preferably surrounded by setters. Being surrounded by setters means that the debindered body and setters are disposed so that the four sides of the debindered body disposed on a setter are surrounded by another setter. When the four sides of the debindered body are surrounded, a gap may be present between the setters. The four sides are surround, and further, a setter is used as a lid to cover the debindered body. In a case where the debindered body is covered with a lid, the setter may be in the form of a container. Surrounding by setters improves the effect of controlling the atmosphere inside the sintering furnace. The thickness of the setter on which the debindered body is placed is preferably not less than 1 mm and not more than 5 mm, and the thickness of the setter surrounding the debindered body is preferably 6 mm or more.

The volume of the disposed debindered body to the space surrounded by the setter is preferably 40 vol% or more. In a case where a plurality of debindered bodies are disposed, the "volume of the debindered body" is the total volume of the plurality of debindered bodies. When the volume of the debindered body is 40 vol% or more, an amount of gas sufficient for controlling the partial pressure in the processing atmosphere can be generated from the debindered body. This facilitates keeping of the pressure inside the sintering furnace at a pressurized atmosphere of 0.6 MPa or more. The upper limit of the volume of the debindered body is not specifically limited, but is preferably 90 vol% or less. If the volume of the debindered body exceeds 90 vol%, the gap between the setter and the debindered body is small, and this may make it difficult to take the sintered body after the sintering out of the setter.

In a case where a plurality of debindered bodies are disposed in a space surrounded by a setter, a part in which the debindered bodies are spaced apart from each other by a distance exceeding 10 mm is preferably not present. For example, in a case where the debindered bodies are disposed in layers, a gap in which the distance between the debindered bodies in the thickness direction exceeds 10 mm is preferably not present. In a case where the debindered bodies are disposed side by side, a gap in which the distance between the debindered bodies in the direction in which the debindered bodies are disposed exceeds 10 mm is preferably not present. For example, in a case where a plurality of sheet-shaped debindered bodies are stacked in close contact with each other, the distance between the debindered bodies is 0 mm. In a case where the debindered bodies are disposed in layers, a bedding powder may be used. It is preferable that one debindered body be present within 10 mm of another debindered body. This enables the paths of the atmospheric gas in the sintering process and the gas generated from the debindered bodies to be more uniform. This also enables the control of the partial pressure in the atmosphere.

Among the use of setters in the sintering, the surrounding of debindered bodies by setters, and the control of the distance between debindered bodies, only any one of these method may be used or more than one of the methods may be combined and used. A combination of all of the methods is most preferable.

It is preferable to perform, during a period in which the debindered body is heated up to the sintering temperature, a heat treatment process in which the debindered body is held at not less than 1400°C and not more than 1650°C for not less than 1 hour and not more than 8 hours. When the heat treatment process is performed, variations in grain growth of the silicon nitride crystal grains can be suppressed. When the particle size of the mixed powder subjected to the pulverizing process is controlled, the effect of suppressing variations in grain growth can be further increased.

A reheat treatment process may be performed after the sintering process as needed. In a case of performing the reheat treatment process, the sintered body is once cooled to room temperature, and thereafter, the sintered body is heated again. The temperature of the reheat treatment is preferably within a range of not less than 1500°C and not more than 1850°C. The reheat treatment process is preferably performed in a pressurized atmosphere of 0.6 MPa or more. The temperature at which pressurization is started when the reheat treatment process is performed is preferably lower than the temperature at which pressurization is started when the sintering process is performed. For example, in a case where pressurization is started at 1000°C during a temperature increase for the sintering process, pressurization is started at less than 1000°C during a temperature increase for the reheat treatment process. When the reheat treatment process is performed, variations in the particle sizes of the silicon nitride crystal grains can be suppressed. When the pressurization start temperature in the reheat treatment process is made lower than the pressurization start temperature in the sintering process, variations in the particle sizes can be suppressed.

With the above-described processes, a silicon nitride substrate (silicon nitride sintered body) can be obtained. When necessary, the obtained silicon nitride substrate may be subjected to surface treatment, such as honing. In a case where the silicon nitride substrate is used in a silicon nitride circuit board, a process for providing a circuit portion on the silicon nitride substrate is performed.

### (Examples 1 to 5 and Comparative Examples 1 and 2)

First, a silicon nitride powder and a sintering aid powder were prepared. The mixed percentage of the silicon nitride powder and that of the sintering aid powder, the average particle size of the silicon nitride powder, the particle size Dₚ₁₀₀ of the silicon nitride powder, the raw material of the sintering aid powder, and the average particle size of the sintering aid powder are shown in Table 1.

**[Table 1]**

| | Silicon nitride powder | | | Sintering aid powder | |
|---|---|---|---|---|---|
| | Mixed amount (mass%) | Average particle size (µm) | Dₚ₁₀₀ (µm) | Raw material (mass%) | Average particle size (µm) |
| Example 1 | 93 | 1.8 | 8 | Y₂O₃(5) | 3.5 |
| | | | | MgO(1) | |
| | | | | TiO₂(1) | |
| Example 2 | 89.5 | 0.8 | 7 | Y₂O₃(4) | 2.8 |
| | | | | Er₂O₃(4) | |
| | | | | MgO(1.5) | |
| | | | | HfO₂(1) | |
| Example 3 | 92 | 0.7 | 9 | Y₂O₃(6) | 2.2 |
| | | | | MgO(2) | |
| Example 4 | 95.5 | 1.8 | 10 | Y₂O₃(3) | 3.8 |
| | | | | MgO(1) | |
| | | | | TiO₂(0.5) | |
| Example 5 | 92.5 | 2.0 | 9 | Y₂O₃(5) | 4.2 |
| | | | | MgO(1.5) | |
| | | | | WO₃(1) | |
| Example 6 | 89.5 | 0.9 | 7 | Y₂O₃(3) | 3.9 |
| | | | | Er₂O₃(5) | |
| | | | | MgO(1.5) | |
| | | | | HfO₂(1) | |
| Comparative example 1 | 93 | 1.8 | 10 | Y₂O₃(5) | 4.7 |
| | | | | MgO(1) | |
| | | | | TiO₂(1) | |
| Comparative example 2 | 93 | 1.8 | 10 | Y₂O₃(5) | 4.8 |
| | | | | MgO(1) | |
| | | | | TiO₂(1) | |

The silicon nitride powder and the sintering aid powder were mixed and subjected to the pulverizing process using a ball mill. Dₘₚ₁₀, Dₘₚ₅₀, and Dₘₚ₉₀ of the mixed powder subjected to the pulverizing process were measured. A laser diffraction method was used to measure the particle size distribution. The difference between Dₘₚ₅₀ and Dₘₚ₁₀ and the difference between Dₘₚ₉₀ and Dₘₚ₅₀ were calculated. The results are shown in Table 2.

**[Table 2]**

| | Mixed powder subjected to pulverizing process | | | | |
|---|---|---|---|---|---|
| | Dₘₚ₁₀ (µm) | Dₘₚ₅₀ (µm) | Dₘₚ₉₀ (µm) | Dₘₚ₅₀-Dₘₚ₁₀ (µm) | Dₘₚ₉₀-Dₘₚ₅₀ (µm) |
| Example 1 | 0.3 | 1.0 | 2.8 | 0.7 | 1.8 |
| Example 2 | 0.2 | 0.5 | 1.4 | 0.3 | 0.9 |
| Example 3 | 0.4 | 0.9 | 2.0 | 0.5 | 1.1 |
| Example 4 | 0.8 | 1.6 | 3.2 | 0.8 | 1.6 |
| Example 5 | 0.8 | 1.8 | 4.2 | 1.0 | 2.4 |
| Example 6 | 0.5 | 0.8 | 1.8 | 0.3 | 1.0 |
| Comparative example 1 | 0.1 | 1.6 | 4.0 | 1.5 | 2.4 |
| Comparative example 2 | 0.5 | 2.1 | 4.8 | 1.6 | 2.7 |

An organic binder and a solvent were mixed with the mixed powder subjected to the pulverizing process to produce a raw material powder slurry. The raw material powder slurry was used to perform sheet forming by the doctor blade method. The long-length sheet was cut to produce a sheet-shaped compact.

The sheet-shaped compact was subjected to the debinding process. In some Examples, the heat treatment process was performed during a temperature increase up to the sintering temperature. In the heat treatment process, the debindered body was held at not less than 1400°C and not more than 1650°C for not less than 1 hour and not more than 8 hours. Table 3 shows whether the heat treatment process was performed and the time of the heat treatment process.

The sheet-shaped debindered body was subjected to the sintering process. In the sintering process, a plurality of sheet-shaped debindered bodies were stacked with a bedding powder interposed. That is, the plurality of sheet-shaped debindered bodies were disposed so that a part in which the distance between the debindered bodies was 0 mm was present. The sintering temperature and the presence or absence of a pressurized atmosphere in the sintering process are shown in Table 3. In Examples, the stacked sheet-shaped debindered bodies were surrounded by a setter. In Examples 1 to 5, the total volume of the stacked sheet-shaped debindered bodies to the volume of the space surrounded by the setter is within a range of not less than 40 vol% and not more than 90 vol%. In Example 6, the total volume with respect to the volume of the space is 95 vol%. In Comparative example 1, only the stacked sheet-shaped debindered bodies were disposed on a plate-shaped setter. That is, in Comparative example 1, the sheet-shaped debindered bodies were not surrounded by a setter.

In some Examples and some Comparative examples, after the sintering process, the temperature is returned to room temperature, and thereafter, the reheat treatment process was performed. In the reheat treatment process, the sintered body was subjected to heat treatment in a pressurized atmosphere within a range of not less than 1500°C and not more than 1850°C. The temperature and the pressure in the reheat treatment process are shown in Table 3. The pressurization start temperature during the temperature increase for the reheat treatment process was made lower than the pressurization start temperature during the temperature increase for the sintering process.

**[Table 3]**

| | Heat treatment process | Sintering process | | | Reheat treatment process | |
|---|---|---|---|---|---|---|
| | Holding time (h) | Sintering temperature (°C) | Sintering time | Pressurized atmosphere (MPa) | Temperature (°C) | Pressurized atmosphere (MPa) |
| Example 1 | 8 | 1800 | 8 | 1.0 | 1750 | 1.3 |
| Example 2 | 5 | 1770 | 9 | 0.7 | 1740 | 1.0 |
| Example 3 | 4 | 1850 | 10 | 0.8 | 1800 | 2.0 |
| Example 4 | 2 | 1860 | 7.5 | 1.4 | 1830 | 1.0 |
| Example 5 | None | 1900 | 6 | 0.6 | None | - |
| Example 6 | 3 | 1900 | 7 | 0.9 | 1820 | 1.0 |
| Comparative example 1 | None | 1800 | 10.5 | None | 1780 | 0.6 |
| Comparative example 2 | None | 1800 | 12 | 0.6 | None | - |

With the above-described processes, a silicon nitride substrate was produced. In any cross section of the silicon nitride substrate, the particle size distribution of the short diameters of silicon nitride crystal grains having an aspect ratio of 2 or less was measured . The measurement was performed for five areas of 256 µm × 172 µm. To measure the particle size distribution of the short diameters, the above-described method was used.

From the particle size distribution obtained as a result of the measurement, the number (first number) of the silicon nitride crystal grains having an aspect ratio of 2 or less was measured. The number (second number) of silicon nitride crystal grains having an aspect ratio of 2 or less and a short diameter of not less than 1.8 µm and not more than 2.2 µm, the number (third number) of silicon nitride crystal grains having an aspect ratio of 2 or less and a short diameter of 4.0 µm or more, the number (fourth number) of silicon nitride crystal grains having an aspect ratio of 2 or less and a short diameter of less than 1.8, and the number (fifth number) of silicon nitride crystal grains having an aspect ratio of 2 or less and a short diameter exceeding 2.2 µm and less than 4.0 µm were measured. Based on these measurement results, the number percentages of the second to fifth numbers to the first number were calculated. The short diameters D₅₀ and D₁₀₀ of the silicon nitride crystal grains having an aspect ratio of 2 or less were measured. The percentage of the total area of the silicon nitride crystal grains having an aspect ratio of 2 or less to the area of the measurement area was calculated. The results are shown in Table 4.

**[Table 4]**

| | Number percentage | | | | D₅₀ (µm) | D₁₀₀ (µm) | Percentage of total area (%) |
|---|---|---|---|---|---|---|---|
| | 1.8-2.2 µm(%) | 4.0 µm or more (%) | Less than 1.8 µm (%) | 2.2-4.0 µm(%) | | | |
| Example 1 | 18 | 4 | 67 | 11 | 1.7 | 12 | 44 |
| Example 2 | 11 | 2 | 72 | 15 | 1.5 | 7 | 53 |
| Example 3 | 14 | 2 | 70 | 14 | 1.6 | 8 | 48 |
| Example 4 | 19 | 3 | 58 | 20 | 1.6 | 11 | 49 |
| Example 5 | 15 | 6 | 61 | 18 | 1.8 | 14 | 47 |
| Example 6 | 15 | 11 | 49 | 25 | 1.4 | 10 | 46 |
| Comparative example 1 | 27 | 8 | 30 | 35 | 3.5 | 18 | 35 |
| Comparative example 2 | 3 | 41 | 25 | 31 | 3.1 | 17 | 38 |

In all Examples, the percentage of the second number to the first number was not less than 5% and not more than 20% and was within the preferable range. In contrast, in Comparative examples, the percentage of the second number to the first number was outside the preferable range. In Comparative examples 1 and 2, although the raw material and the percentage of the sintering aid were substantially the same as those in Example 1, the particle size distribution of the short diameter was different from that in Example 1. This is because in Comparative examples 1 and 2, the average particle size of the mixed powder subjected to the pulverizing process was outside the preferable range and the conditions of the sintering process were outside the preferable ranges.

Further, in Examples 1 to 6, the silicon nitride substrate was measured in the direction perpendicular to the cross section for which the particle size distribution was measured to obtain a new cross section. In the new cross section, measurement was performed for five areas of 256 µm × 172 µm to obtain the particle size distribution. From the results, the number percentages of the second to fifth numbers to the first number were calculated. As a result, even in the new cross section, the percentage of the second number to the first number was not less than 5% and not more than 20% and was within the preferable range.

Next, the three-point bending strength, fracture toughness, and thermal conductivity of the silicon nitride substrate were measured. The results are shown in Table 5. The measurement methods for the three-point bending strength, fracture toughness, and thermal conductivity are as described above.

**[Table 5]**

| | Three-point bending strength (MPa) | Fracture toughness (MPa·m^{½}) | Thermal conductivity (W/m·K) |
|---|---|---|---|
| Example 1 | 670 | 7.5 | 95 |
| Example 2 | 710 | 7.0 | 100 |
| Example 3 | 720 | 7.2 | 105 |
| Example 4 | 680 | 7.5 | 95 |
| Example 5 | 660 | 7.9 | 90 |
| Example 6 | 600 | 8.0 | 105 |
| Comparative example 1 | 560 | 8.1 | 110 |
| Comparative example 2 | 630 | 7.9 | 90 |

In each Example and each Comparative example, a silicon nitride substrate having a length of 60 mm and a width of 50 mm was produced under the conditions shown in Tables 1 to 3. In Examples 1 to 3, Example 6, and Comparative example 1, the thickness of the silicon nitride substrate is 0.32 mm. In Example 4, Example 5, and Comparative example 2, the thickness of the silicon nitride substrate is 0.25 mm.

An active metal method was used to bond a copper plate having a thickness of 0.8 mm to both faces of the silicon nitride substrate. The copper plate on the front face was subjected to an etching process to give a circuit shape. Accordingly, a silicon nitride circuit board was prepared.

The bonding strength and TCT characteristics of the copper plates in the silicon nitride circuit board were measured. The bonding strength was measured by a peel test. The TCT conditions were set such that one cycle includes -40°C for 30 minutes → room temperature for 10 minutes → 170°C for 30 minutes → room temperature for 10 minutes, and 3000 cycles were performed. The presence or absence of cracks in the silicon nitride substrate after the TCT was determined. In each Example and each Comparative example, the bonding strengths and TCT characteristics of ten silicon nitride circuit boards were measured. The results are shown in Table 6. The bonding strength in Table 6 is the average of the bonding strengths of the ten silicon nitride circuit boards. Regarding the TCT characteristics, an example in which no cracks were generated in any of the silicon nitride substrates is shown as "no", and an example in which a crack was observed in any of the silicon nitride substrates is described as "present".

**[Table 6]**

| | Bonding strength (N/mm) | Presence or absence of cracks in silicon nitride substrate after TCT | Thickness of silicon nitride substrate (mm) |
|---|---|---|---|
| Example 1 | 25 | No | 0.32 |
| Example 2 | 28 | No | 0.32 |
| Example 3 | 27 | No | 0.32 |
| Example 4 | 25 | No | 0.25 |
| Example 5 | 23 | No | 0.25 |
| Example 8 | 20 | No | 0.32 |
| Comparative example 1 | 18 | Present | 0.32 |
| Comparative example 2 | 16 | Present | 0.25 |

From the results shown in Table 6, in Examples 1 to 6, higher bonding strength was obtained than in Comparative examples 1 and 2. Further, in Examples 1 to 6, improvement of TCT characteristics was confirmed as compared with Comparative examples 1 and 2. For example, small cracks were observed in the silicon nitride substrates in Comparative examples 1 and 2. From these results, it is found that the control of the short diameters of the silicon nitride crystal grains can improve strength against stresses generated in various directions. It is also found that the control is effective in improving the bonding strength.

Embodiments of the invention include the following features.

### (Feature 1)

A silicon nitride sintered body including silicon nitride crystal grains,
in a case where an area of 256 µm × 172 µm in a first cross section is observed with an SEM, the first cross section being any cross section, a percentage of a second number of silicon nitride crystal grains having an aspect ratio of 2 or less and a short diameter of not less than 1.8 µm and not more than 2.2 µm to a first number of silicon nitride crystal grains having an aspect ratio of 2 or less being within a range of not less than 5% and not more than 20%.

### (Feature 2)

The silicon nitride sintered body according to Feature 1, in which, a percentage of a third number of silicon nitride crystal grains having an aspect ratio of 2 or less and a short diameter of 4.0 µm or more to the first number in the area is within a range of not less than 0% and not more than 10%.

### (Feature 3)

The silicon nitride sintered body according to Feature 1 or 2, in which, a percentage of a fourth number of silicon nitride crystal grains having an aspect ratio of 2 or less and a short diameter of less than 1.8 µm to the first number in the area is within a range of not less than 45% and not more than 75%.

### (Feature 4)

The silicon nitride sintered body according to any one of Features 1 to 3, in which, a percentage of a fifth number of silicon nitride crystal grains having an aspect ratio of 2 or less and a short diameter exceeding 2.2 µm and less than 4.0 µm to the first number in the area is within a range of not less than 10% and not more than 25%.

### (Feature 5)

The silicon nitride sintered body according to any one of Features 1 to 4, in which
a short diameter (D₅₀) of the silicon nitride crystal grains having an aspect ratio of 2 or less is not less than 1.30 µm and less than 1.80 µm in the area, and
50% of the silicon nitride crystal grains having an aspect ratio of 2 or less have a short diameter of not more than the short diameter (D₅₀).

### (Feature 6)

The silicon nitride sintered body according to any one of Features 1 to 5, in which a maximum value of short diameters of the silicon nitride crystal grains having an aspect ratio of 2 or less is not less than 3.00 µm and less than 15.00 µm.

### (Feature 7)

The silicon nitride sintered body according to any one of Features 1 to 6, in which a percentage of an area occupied by the silicon nitride crystal grains having an aspect ratio of 2 or less to the area of 256 µm × 172 µm is within a range of not less than 30% and not more than 70%.

### (Feature 8)

The silicon nitride sintered body according to any one of Features 1 to 7, in which the silicon nitride sintered body has a fracture toughness of 7 MPa·m^{1/2} or more.

### (Feature 9)

The silicon nitride sintered body according to any one of Features 1 to 8, in which the silicon nitride sintered body has a thermal conductivity of 90 W/m·K or more.

### (Feature 10)

The silicon nitride sintered body according to any one of Features 1 to 9, in which the silicon nitride sintered body has a thickness of not less than 0.2 mm and not more than 3 mm.

### (Feature 11)

The silicon nitride sintered body according to any one of Features 1 to 10, in which the silicon nitride sintered body has a three-point bending strength of 400 MPa or more.

### (Feature 12)

The silicon nitride sintered body according to any one of Features 1 to 11, in which in a case where an area of 256 µm × 172 µm in a second cross section perpendicular to the first cross section is observed with an SEM, a percentage of a number of the silicon nitride crystal grains having an aspect ratio of 2 or less and a short diameter of not less than 1.8 µm and not more than 2.2 µm to a number of the silicon nitride crystal grains having an aspect ratio of 2 or less is within a range of not less than 5% and not more than 20%.

### (Feature 13)

A silicon nitride circuit board including:
a silicon nitride substrate in which the silicon nitride sintered body according to any one of Features 1 to 12 is used;
a metal plate bonded to at least one of faces of the silicon nitride sintered body; and
a brazing filler layer bonding the silicon nitride sintered body and the metal plate together.

### (Feature 14)

The silicon nitride circuit board according to Feature 13, in which the metal plate is a copper plate.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the invention. Moreover, above-mentioned embodiments can be combined mutually and can be carried out.

### [Reference Numeral List]

1 cross-sectional structure
2 silicon nitride crystal grains having aspect ratio of 2 or less
3 silicon nitride crystal grains having aspect ratio exceeding 2
4 grain boundary phase
5 silicon nitride substrate
6 bonding layer
7 metal plate
8 stress
10 silicon nitride circuit board

## Claims

1. A silicon nitride sintered body comprising silicon nitride crystal grains,
in a case where an area of 256 µm × 172 µm in a first cross section is observed with an SEM, the first cross section being any cross section, a percentage of a second number of silicon nitride crystal grains having an aspect ratio of 2 or less and a short diameter of not less than 1.8 µm and not more than 2.2 µm to a first number of silicon nitride crystal grains having an aspect ratio of 2 or less being within a range of not less than 5% and not more than 20%.

2. The silicon nitride sintered body according to claim 1, wherein, a percentage of a third number of silicon nitride crystal grains having an aspect ratio of 2 or less and a short diameter of 4.0 µm or more to the first number in the area is within a range of not less than 0% and not more than 10%.

3. The silicon nitride sintered body according to claim 1 or 2, wherein, a percentage of a fourth number of silicon nitride crystal grains having an aspect ratio of 2 or less and a short diameter of less than 1.8 µm to the first number in the area is within a range of not less than 45% and not more than 75%.

4. The silicon nitride sintered body according to any one of claims 1 to 3, wherein, a percentage of a fifth number of silicon nitride crystal grains having an aspect ratio of 2 or less and a short diameter exceeding 2.2 µm and less than 4.0 µm to the first number in the area is within a range of not less than 10% and not more than 25%.

5. The silicon nitride sintered body according to any one of claims 1 to 4, wherein
a short diameter (D₅₀) of the silicon nitride crystal grains having an aspect ratio of 2 or less is not less than 1.30 µm and less than 1.80 µm in the area, and
50% of the silicon nitride crystal grains having an aspect ratio of 2 or less have a short diameter of not more than the short diameter (D₅₀).

6. The silicon nitride sintered body according to any one of claims 1 to 5, wherein a maximum value of short diameters of the silicon nitride crystal grains having an aspect ratio of 2 or less is not less than 3.00 µm and less than 15.00 µm.

7. The silicon nitride sintered body according to any one of claims 1 to 6, wherein a percentage of an area occupied by the silicon nitride crystal grains having an aspect ratio of 2 or less to the area of 256 µm × 172 µm is within a range of not less than 30% and not more than 70%.

8. The silicon nitride sintered body according to any one of claims 1 to 7, wherein the silicon nitride sintered body has a fracture toughness of 7 MPa·m^{1/2} or more.

9. The silicon nitride sintered body according to any one of claims 1 to 8, wherein the silicon nitride sintered body has a thermal conductivity of 90 W/m·K or more.

10. The silicon nitride sintered body according to any one of claims 1 to 9, wherein the silicon nitride sintered body has a thickness of not less than 0.2 mm and not more than 3 mm.

11. The silicon nitride sintered body according to any one of claims 1 to 10, wherein the silicon nitride sintered body has a three-point bending strength of 400 MPa or more.

12. The silicon nitride sintered body according to any one of claims 1 to 11, wherein in a case where an area of 256 µm × 172 µm in a second cross section perpendicular to the first cross section is observed with an SEM, a percentage of a number of the silicon nitride crystal grains having an aspect ratio of 2 or less and a short diameter of not less than 1.8 µm and not more than 2.2 µm to a number of the silicon nitride crystal grains having an aspect ratio of 2 or less is within a range of not less than 5% and not more than 20%.

13. A silicon nitride circuit board comprising:
a silicon nitride substrate in which the silicon nitride sintered body according to any one of claims 1 to 12 is used;
a metal plate bonded to at least one of faces of the silicon nitride sintered body; and
a brazing filler layer bonding the silicon nitride sintered body and the metal plate together.

14. The silicon nitride circuit board according to claim 13, wherein the metal plate is a copper plate.
